Europäisches Patentamt

European Patent Office

Office européen des brevets

(19)

(11) Publication number: **0 029 932**
**B1**

# EUROPEAN PATENT SPECIFICATION

(45) Date of publication of patent specification: **15.08.84**

(21) Application number: **80106861.0**

(22) Date of filing: **07.11.80**

(51) Int. Cl.³: **H 01 L 29/74,**
**H 01 L 29/743,**
**H 01 L 29/10**

(54) Asymmetrical field controlled thyristor.

(30) Priority: **16.11.79 US 94943**

(43) Date of publication of application:
**10.06.81 Bulletin 81/23**

(45) Publication of the grant of the patent:
**15.08.84 Bulletin 84/33**

(84) Designated Contracting States:
**CH DE FR GB LI SE**

(56) References cited:
**DE - A - 3 002 526**
**FR - A - 2 394 175**
**FR - A - 2 433 239**
**US - A - 4 060 821**

**IEEE TRANSACTIONS ON ELECTRON DEVICES,
vol. ED-27, no. 7, July 1980 NEW YORK (US)
B.J. BALIGA: "The asymmetrical field-controlled
thyristor", pages 1262-1267
PATENTS ABSTRACTS OF JAPAN, vol. 2, no.
17, February 6, 1978, page 11035 E 77
MICROELECTRONICS AND RELIABILITY, vol.
16, 1977 OXFORD (GB) A. COLENS: "Design and
applications of high-power ultrasonic converters
using ASCR's", pages 487-508**

(73) Proprietor: **GENERAL ELECTRIC COMPANY**
**1 River Road**
**Schenectady New York 12305 (US)**

(72) Inventor: **Baliga, Bantval Jayant**
**3 Clove court**
**Clifton Park New York (US)**

(74) Representative: **Sieb, Rolf, Dr. et al,**
**Kaiserstrasse 41**
**D-6000 Frankfurt (Main) 1 (DE)**

Courier Press, Leamington Spa, England.

# Description

This invention relates to an asymmetrical field controlled thyristor according to the first part of claim 1 and to a method of fabricating an asymmetrical field controlled thyristor.

A thyristor according to the first part of claim 1 is known from FR—A—2 394 175.

A field controlled thyristor typically comprises a P+N N+ rectifier with the N base containing heavily doped P+ gate regions. The device is operated by maintaining the N+ cathode at ground potential while applying bias voltages on the anode and gate terminals. In absence of any applied potential on the gate regions, the device behaves as a conventional rectifier. Consequently, the device is capable of conducting large current with low forward voltage drop when a positive bias is applied to the anode terminal, and can block current flow when negative bias is applied to the anode terminal. The gate regions of a field controlled thyristor are designed to pinch off current flow between anode and cathode when the gate is biased negative with respect to the cathode. The gate regions, therefore, provide the device with a forward blocking capability similar to that of a conventional thyristor. Field controlled thyristors with good operating characteristics are those that can block large anode voltages with small gate voltages. Therefore, the ratio of anode voltage, at the onset of anode current flow, to applied gate voltage at that instant is an important parameter for these devices and is termed the blocking gain. This blocking gain is a strong function of the geometrical shape of the channel formed between the gate regions, and is also dependent on the N base resistivity. In addition to providing the device with forward blocking capability, the gate regions can also be used to extinguish anode current when the device is in its conductive state. If a reverse bias is applied to the gate when the device is conducting anode current, the gate depletion layer extends into the channel and pinches off the anode current. This gate voltage induced turn-off feature provides the field controlled thyristor with a high speed switching capability, making it applicable to higher frequencies than achievable with conventional thyristors.

Two basic types of field controlled thyristor gate structures are well known. These are the buried grid gate structure and the surface grid gate structure. The buried grid devices have been fabricated by diffusion of P+ grid fingers (or a mesh) into an N type substrate, followed by growth of an N type epitaxial layer over the diffused area. The buried grid structure has also been produced by ion-implantation of boron into an N type substrate. These devices exhibit moderate blocking gains (20—40) but have a limited gate turn-off capability due to the inherently high resistance of even heavily doped buried grid fingers which causes debiasing of the grid fingers during turn-off. This limitation has motivated development of surface gate devices with very low gate resistances achieved by contacting the gate fingers along their entire lengths with patterned metallization. Early surface gate devices of this type were fabricated by planar diffusion of boron into 60 ohm-cm N type substrates. Despite a diffusion depth of 10 micrometers, the cylindrical shape of the planar diffused gate regions resulted in an open channel structure which had a low blocking gain (5 to 7). To increase the blocking gain, an improved surface gate structure, with steep vertical gate walls, has been recently developed by using orientation dependent etching and selective vapor phase epitaxial growth in the etched grooves. With this device structure, blocking gains as high as 45 have been achieved at groove depths of about 40 micrometers. These devices have also exhibited very fast gate turn-off speeds. However, the fabrication process for these devices is complex and results in a low device yield.

By use of the present invention as claimed, a power field controlled thyristor with significant improvements in blocking gain, turn-off speed and on-state forward voltage drop can be achieved. This device structure, however, has a limited reverse blocking capability and hence is termed an asymmetrical field controlled thyristor. This reduced reverse blocking capability is not a serious disadvantage in many high frequency inverter applications where antiparallel diodes are used. The new configuration described herein is of particular importance to surface gate devices because very high blocking gains can be achieved with this structure, even though conventional planar processing is employed for device fabrication. This greatly simplifies fabrication of the device and results in a higher yield during fabrication in comparison with the earlier surface gate devices.

Briefly in accordance with a preferred embodiment of the invention, an asymmetrical field controlled thyristor comprises a semiconductor anode region of one type conductivity and a dual-layer base region adjoining the anode region and being comprised of an integral portion of the semiconductor material with an opposite type conductivity, the layer of the dual-layer base region closest to the anode region being doped at a higher concentration of the opposite conductivity type-determining dopants than the layer of the dual-layer base region farthest from the anode region. A cathode region adjoins the layer of the dual-layer base region farthest from the anode region and is comprised of the semiconductor material of the opposite type conductivity. The cathode region is doped at a higher concentration of the opposite conductivity type-determining dopants. A plurality of semiconductor gate regions are provided and are spaced apart from the cathode region on either side thereof. The gate regions adjoin the layer of the dual-layer base region farthest from the anode region and are comprised of the semiconductor material of the one type conductivity. First, second and third conductive means are provided for contacting the outermost surface of the cathode region, the gate regions, and the anode region, respectively.

In accordance with another preferred embodiment of the invention, a method of fabricating an asymmetrical field controlled thyristor comprises oxidizing a major surface of a semiconductor substrate of said opposite type conductivity having two major surfaces, and diffusing dopants into the unoxidized major surface of the substrate to form a more heavily doped layer in the semiconductor substrate than the remaining portion of the substrate, the more heavily doped layer being of the same type conductivity as that of the remaining portion of the substrate. The oxide layer is then patterned to open a gate diffusion area therein, and dopants are diffused into the substrate through both major surfaces so as to produce a plurality of gate regions of said one type conductivity adjoining the remaining portion of the substrate and an anode region of said one type conductivity adjoining the more heavily doped layer in the substrate. The oxide layer is next patterned to open only a cathode diffusion area therein, and dopants are diffused into the substrate through the cathode diffusion area so as to provide a cathode region of said opposite type conductivity adjoining the remaining portion of the substrate. A layer of metal is then applied over the outermost surfaces of the cathode and gate regions, and is patterned to obtain separate contacts to the cathode regions and to the gate regions respectively. A layer of metal is also applied over the outermost surface of the anode region in order to make contact therewith.

The invention may best be understood by reference to the following description taken in conjunction with the accompanying drawings in which:

Fig. 1A represents a sectional, schematic view of a conventional field controlled thyristor structure;

Fig. 1B is a graphical illustration of the doping profile for the device of Fig. 1A, with dopant concentration at section 1—1' in Fig. 1A plotted along the abscissa and depth beneath the uppermost surface of the device plotted along the ordinate;

Fig. 1C is a graphical representation of the electric field distribution in the device of Fig. 1A, with electric field strength at section 1—1' in Fig. 1A plotted along the abscissa and depth beneath the uppermost surface of the device plotted along the ordinate;

Fig. 1D illustrates the location of the depletion layer in the device of Fig. 1A;

Fig. 2A represents a sectional, schematic view of the asymmetrical field controlled thyristor structure of the present invention;

Fig. 2B is a graphical illustration of the doping profile for the device of Fig. 2A, with dopant concentration at section 2—2' in Fig. 2A plotted along the abscissa and depth beneath the uppermost surface of the device plotted along the ordinate;

Fig. 2C is a graphical representation of the electric field distribution in the device of Fig. 2A, with electric field strength at section 2—2' in Fig. 2A plotted along the abscissa and depth beneath the uppermost surface of the device plotted along the ordinate;

Fig. 2D illustrates the location of the depletion layer in the device of Fig. 2A; and

Figs. 3A—3F are sectional, schematic representations of the structure of the asymmetrical field controlled thyristor of the present invention, as it progresses through successive stages in its fabrication process.

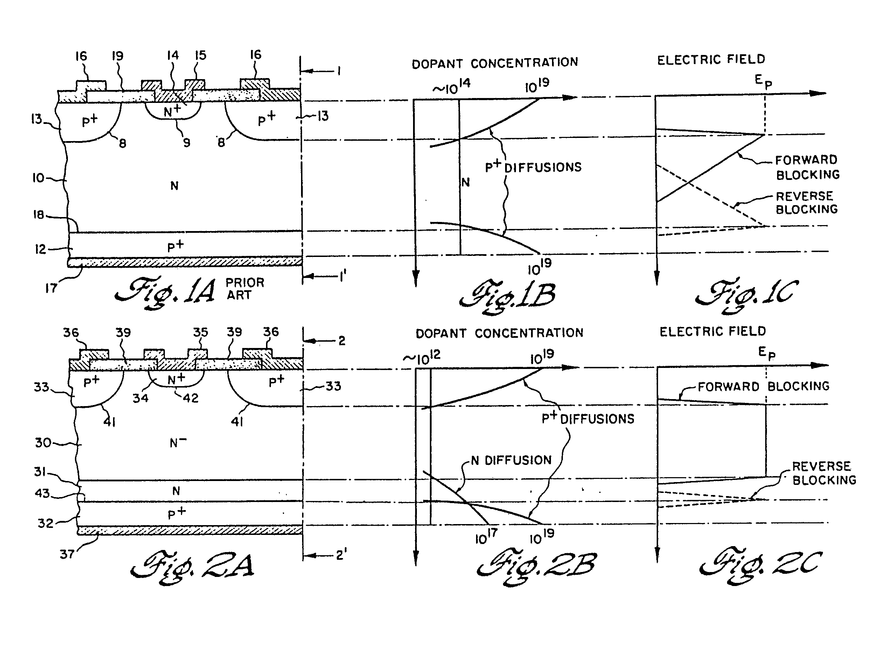

In Fig. 1A, a conventional field controlled thyristor is illustrated as comprised of semiconductor material with an N type base region 10, a P+ anode region 12, P+ grid regions 13, and an N+ cathode region 14. N base region 10 forms gate interfaces 8 and a cathode interface 9 with gate regions 13 and cathode region 14, respectively, and forms an anode interface 18 with anode region 12. Cathode, grid and anode contacts 15, 16 and 17, respectively, are provided, typically in the form of aluminum metallization, with the remainder of the uppermost surface of the device passivated by silicon oxide layer 19.

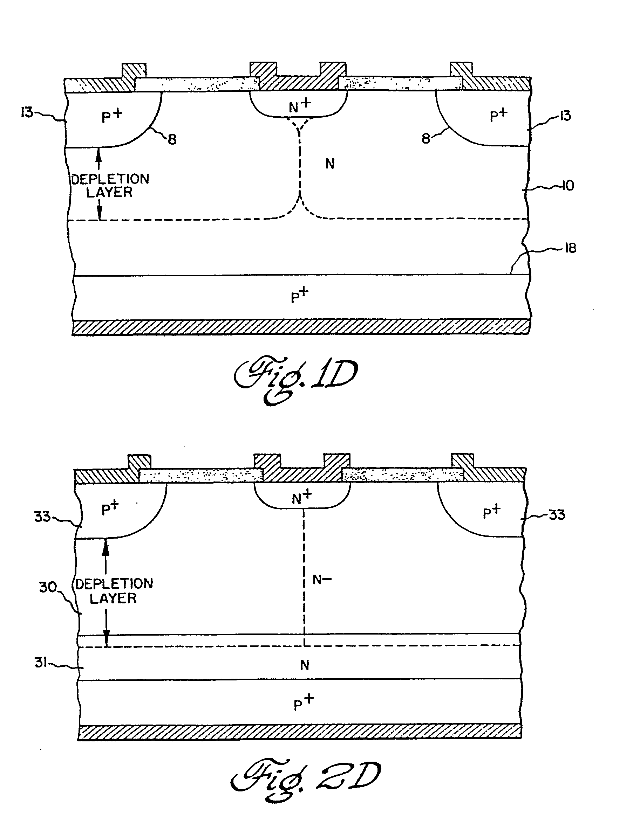

In Fig. 2A, the asymmetrical field controlled thyristor of the instant invention is illustrated as comprised of semiconductor material with a dual-layer N type base including a lightly doped N— portion 30 and a more heavily doped N portion 31. The remainder of the structure is similar to that of Fig. 1A in that it includes a P+ anode region 32, P+ grid regions 33, and an N+ cathode region 34. N— base layer 30 forms gate interfaces 41 and a cathode interface 42 with gate regions 33 and cathode region 34, respectively, and N base layer 31 forms an anode interface 43 with anode region 32. Cathode, grid and anode contacts 35, 36 and 37, respectively, are provided, typically in the form of aluminum metallization, and the remainder of the uppermost surface of the device is passivated by silicon oxide layer 39.

Associated with the devices of Figs. 2A and 1A are the doping profiles of the respective devices, shown in Figs. 2B and 1B, respectively, and the electric field distribution in the respective devices during both forward blocking and reverse blocking, as shown in Figs. 2C and 1C, respectively. The field controlled thyristor of the present invention, shown in Fig. 2A, should be contrasted with the conventional device structure shown in Fig. 1A. Thus the structure illustrated of the device of the present invention is similar to that of a conventional field controlled thyristor except that the N base of the device of the present invention comprises a two layer N base made up of very lightly doped region 30 near the gate and cathode regions and more heavily doped region 31 near the anode region. This modification of the doping profile exerts a strong influence upon electric field distribution in both the forward and reverse blocking stages of device operation which, in turn, results in significant improvement in forward blocking capability as described, infra. The change in doping profile also results in a significant improvement in forward voltage drop.

Due to the parasitic PNP transistor extant between gate 13 and anode 12 in conventional field controlled thyristors, such as shown in Fig. 1A, breakdown voltage of the field controlled thyristor is limited by open base transistor breakdown. In the conventional device structure therefore, optimum breakdown voltage with the lowest forward voltage drop is achieved by use of an N base 10 width of about one diffusion length longer than the maximum depletion width at avalanche breakdown of the base material. That is, maximum forward blocking voltage is limited by the PNP punch-through breakdown between grid junctions 8 and anode junction 18. This occurs when the depletion layer in N base 10, extending to the dashed line in N base 10 as shown in Fig. 1D, approaches to within approximately one diffusion length of anode junction 18. The grid bias required to achieve blocking is determined by the blocking gain. This blocking gain is a function of N base 10 resistivity as well as the grid 13 spacing and geometry.

In the new device structure, shown in Fig. 2A, the transistor punch-through breakdown is prevented by incorporating into the N base a more heavily doped region 31 near the anode. This allows use of a very low doping level for the remainder 30 of the N base without encountering the open base transistor breakdown effect.

When junctions 41 of the device shown in Fig. 2A are reverse-biased during the forward blocking mode of operation, the gate depletion layer, extending to the dashed line in N base layer 31 as shown in Fig. 2D, contains a low ionized impurity density which results in maintaining a high electric field throughout the depth of lightly doped N— base portion 30, as shown in Fig. 2C. The electric field then decreases very sharply in the more heavily doped N base region 31, thus preventing punch-through breakdown. In contrast, the uniform doping of N base 10 in the conventional device structure shown in Fig. 1A produces a steadily decreasing electric field in N base 10 with its peak at gate junction 8, as shown in Fig. 1C. Because the voltage supported between the gate and anode terminals is given by the area under the electric field profile, it is evident from Figs. 1C and 2C that, during forward blocking conditions, the structure of Fig. 2A exhibits a substantially higher breakdown voltage for the same total wafer thickness and junction diffusion depths than the structure of Fig. 1A. There

is, however, no substantial difference in forward voltage drop during current conduction since the two devices are alike in wafer thickness and in junction depths of anode and cathode regions. Thus the N base doping profile for the device of Fig. 2A results in a higher forward blocking capability than that of the device in Fig. 1A, while maintaining the same forward voltage drop during current conduction.

As an example of the improvement in breakdown voltage provided by the device of Fig. 2A over the device of Fig. 1A, if a 1,000 volt conventional device design is considered, N base resistivity is substantially 35 ohm-cm. At avalanche breakdown, this N base material has a depletion width of substantially 90 micrometers. Since a diffusion length of at least 40 micrometers is required to maintain a low forward voltage-drop, the total N base width of the conventional device would be about 130 micrometers. In the new device structure, however, thickness of more heavily doped N base portion 31 is about 30 micrometers to prevent gate depletion layer punch-through to anode region 32. Consequently, for the same wafer thickness, the lightly doped N— base portion 30 of the new device structure would have a thickness of about 100 micrometers. The low doping level of this region results in a uniform electric field, as shown in Fig. 2C, which has a value $E_p$ of about $2 \times 10^5$ V/cm at breakdown as pointed out in S. M. Sze and G. Gibbons, "Avalanche Breakdown Voltages of Abrupt and Linearly Graded p-n Junctions in Ge, Si, GaAs, and GaP", *Applied Physics Letters*, Vol. *8*, pp 111—113 (1976). As a result, forward blocking capability of the device of Fig. 1A extends to about 2,000 volts. Thus, a twofold increase in blocking voltage can be expected while maintaining the same forward voltage drop.

Use of lightly doped N— base portion 30 in the gate area of the device of Fig. 2A results in a very large increase in blocking gain over devices of the type shown in Fig. 1A. Since the doping level of the entire N base is lower in region 30, the depletion layers from gate regions 33 extend into the channel area at lower gate voltages than from gate regions 13 in the device shown in Fig. 1A. As a result, the anode-cathode current is pinched off at a lower gate voltage than in the device shown in Fig. 1A, thus providing increased blocking gain. Moreover, if channel width is small and N— base portion 30 is very lightly doped, the diffusion potential of gate junctions 41 can be sufficient to cause gate depletion layer punch-through under the channel. Under these conditions, anode-cathode current flow terminates with zero bias on the gate. However, the potential barrier in the channel at zero gate bias is small and can therefore prevent anode-cathode current flow only at anode voltages below 100 volts. Further, due to this depletion layer punch-through at low gate voltages, high blocking gains can be obtained by use of the planar diffusion process, eliminating need for use of the more complex epitaxial-refill technology that has heretofore been required to achieve high blocking gains. Device processing yields may consequently be expected to improve.

Another significant advantage of the structure shown in Fig. 2A is improved gate turn-off capability. In the conventional device structure shown in Fig. 1A, gate turn-off is achieved at gate voltages which create a depletion layer that pinches off the anode-cathode current, but with the depletion layer extending only a short distance from the gate junction as shown in Fig. 1D. As a result, the gate depletion layer sweeps out only a small fraction of the charge which is injected into N base 10 during forward conduction. The remaining charge in N base 10 must then decay by recombination. This causes the anode-cathode current to gradually tail off, decreasing switching speed of the device. In contrast, the very low doping level of upper N— base layer 30 in the asymmetrical field controlled thyristor shown in Fig. 2A results in the gate depletion layer extending entirely through N— base layer 30, as shown in Fig. 2D, even at low gate voltages. As a result, most of the charge injected into the N base during forward conduction is swept out when gate 33 is reverse-biased. This leaves only a small fraction of the charge to decay by recombination, thus improving switching speed of the devices.

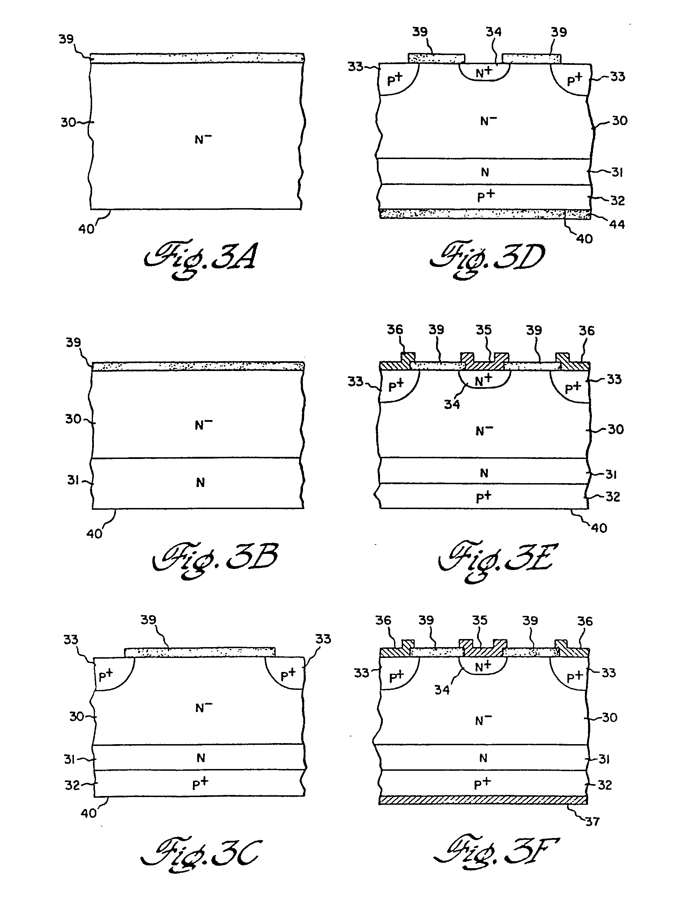

Fabrication of the asymmetrical field controlled thyristor of the present invention begins with high resistivity, N type silicon wafers, such as wafer 30, shown in Fig. 3A. A typical resistivity is 2,000 ohm-cm, although resistivity above 50 ohm-cm is suitable, depending upon the breakdown voltage desired for the device. The higher resistivities should be selected for devices requiring higher breakdown voltages and high blocking gains.

Wafer 30 is first oxidized, preferably in a steam-oxygen mixture at 1150°C, to obtain a silicon oxide layer of 1 $\mu$m (10,000 angstroms) on the surface. This oxide layer is then removed on the lowermost or back surface 40 of the wafer, which is to serve as the anode region of the device being fabricated, leaving oxide layer 39 on the upper surface.

A phosphorous diffusion is performed on back surface 40 of the wafer to obtain a diffused layer 31 with a surface concentration of about $2 \times 10^{17}$ dopant atoms per cc and a depth of 30—50 micrometers. Typical phosphorous deposition may be performed at 800°C for 30 minutes using phosphorous oxychloride, followed by a drive-in cycle at 1250°C for 50 hours, resulting in the structure shown in Fig. 3B.

Oxide layer 39 on the uppermost or front surface of the wafer is next patterned using conventional photolithography to open the gate diffusion area, and oxide on back surface 40 of the wafer is also removed at this time. A boron diffusion is then performed on both sides of the wafer, so as to diffuse boron therein through both major surfaces of the wafer. Typical diffusion may be performed at 975°C for one hour using boron nitride source wafers, followed by a drive-in cycle at 1250°C for two hours. This diffusion simultaneously creates anode region 32 and gate regions 33, with a surface concentration of about $1 \times 10^{19}$ cm$^{-3}$ and a junction depth of about 5 micrometers, as shown in Fig. 3C. However, separate boron diffusions may alternatively be performed to fabricate these regions if desired.

Oxide layer 39 on the front surface of the wafer is next patterned by conventional photolithography to open the cathode diffusion area. The oxide layer 44 formed on the back surface of the wafer is not removed during this step. A phosphorous diffusion is then performed to create the source or cathode region 34. Diffusion is typically performed with a deposition at 900°C for 30 minutes followed by a drive-in cycle at 1000°C for 30 minutes to obtain a junction depth of 1.5 micrometers and a surface concentration of $1 \times 10^{19}$ cm$^{-3}$, resulting in the structure shown in Fig. 3D.

Oxide layer 39 is again photolithographically patterned to open contact windows for the cathode and gate, while the oxide layer on back surface 40 is removed to open a contact area for the anode. Aluminum is then evaporated on the front surface to a thickness of 1—2 micrometers, and patterned photolithographically to obtain contacts 35 and 36 to the gate and cathode areas, respectively, as shown in Fig. 3E. An aluminum layer 37 is next evaporated on the anode side of the wafer, and sintered at 400°C for 30 minutes to lower contact resistance, resulting in the structure illustrated in Fig. 3F.

A typical device formed according to the aforementioned processing steps may be fabricated with a plurality of cathode fingers, each cathode finger having a width of 10 micrometers and a length of 750 micrometers. The cathode fingers are inter-digitated with, and surrounded by, the gate region. Breakdown voltage of these devices has been found to increase with wafer thickness (or depth), and ranges from 500 volts for wafers of 127 $\mu$m (5 mil) thickness to 1000 volts for wafers of 254 $\mu$m (10 mil) thickness. Moreover, for wafers of 254 $\mu$m (10 mil) thickness, the fabricated device can block an anode voltage of over 950 volts with an applied gate bias of about 14 volts, so that DC blocking gain exceeds 65.

Blocking gain of the asymmetrical field controlled thyristors fabricated in accordance with the present invention has been found to be a function of N base thickness, even with gate junction depth held unchanged; that is, maximum anode blocking voltage increases with N base width. This is to be expected since the high electric field is maintained over a wider N base as wafer thickness increases. In addition, blocking gain has also been found to be dependent upon N base width, and increases by more than a factor of 3 in going from a base width of 65 micrometers to a base width of 190 micrometers. This dependence of the blocking gain on the N base width arises from the very low N base doping level, which results in the gate depletion layer extending across the entire N base of these devices for all wafer thicknesses, under forward blocking conditions. The pinch-off region in the channel, therefore, extends all the way from cathode 34 to N type diffused buffer layer 31.

As previously noted, the device of Fig. 2A is designed to allow the gate depletion layer to punch through in the channel region without any applied gate bias. This gives the device ability to block anode current even without an applied reverse gate bias. However, the potential barrier created in the channel by the inherent potential of gate junction 41 is sufficient to block current flow only at low anode voltages; that is, as anode voltage is increased, the device switches from the blocking state to the conductive state.

When the device of Fig. 2A is operating in the conductive state, its characteristics resemble those of a rectifier diode. At low anode currents, the device current increases exponentially with anode voltage and the device exhibits a low forward voltage drop due to conductivity modulation of the dual-layer N base by the injected holes and electrons from the anode and cathode regions, respectively. This conductivity modulation decreases as N base width is increased, and results in an increase in forward voltage drop with increasing base width. While the effect of increasing the base width on forward voltage drop is small at low current densities, it becomes quite severe at higher current densities. At a device current of 10 amperes, cathode current density exceeds 1000 A/cm². At these current densities, diffusion length of the carriers in the N base region is decreased, reducing the conductivity modulation more severely in the wider N base devices to produce the aforementioned increase in forward voltage drop. However, a conventional field controlled thyristor with the same forward blocking capability would require a wider N base and would, therefore, exhibit a considerably higher forward voltage drop than the device shown in Fig. 2A.

The foregoing describes a field controlled thyristor with gate turn-off capability and high blocking gain. The device exhibits a low forward voltage drop and a high speed switching capability. The power field controlled thyristor of the invention readily lends itself to fabrication by conventional planar semiconductor diffusion technology.

**Claims**

1. An asymmetrical field controlled thyristor comprising:

a semiconductor anode region (32) of one type conductivity;

a dual layer base region (30, 31) adjoining said anode region and being comprised of an integral portion of semiconductor material with opposite type conductivity;

a cathode region (34) adjoining said layer of said dual-layer base region farthest from said anode region and being comprised of semiconductor material of said opposite type conductivity, said cathode region being doped at a higher concentration of said opposite conductivity type-determining dopants than both layers of said dual layer base region;

a semiconductor gate region (33) spaced apart from said cathode region, said gate region adjoining said base region and being comprised of semiconductor material of said one type conductivity;

first conductive means (35) contacting the outermost surface of said cathode region;

second conductive means (36) contacting the outermost surface of said gate region; and

third conductive means (37) contacting the outermost surface of said anode region of one type conductivity;

characterized by the layer (31) of said dual-layer base region closest to said anode region being doped at a higher concentration of opposite conductivity type determining dopants than the layer (30) of said dual-layer base region farthest from said anode region, and said semiconductor gate region (33) being a surface gate adjoining said layer (30) of said dual-layer base region farthest from said anode region.

2. The thyristor of Claim 1 characterized in that the semiconductor material of said one type conductivity consists of a P type semiconductor and said material of said opposite type conductivity consists of a N type semiconductor.

3. The thyristor of Claim 1 or 2 characterized in that the semiconductor material comprises silicon.

4. The thyristor of Claims 1 or 2 or 3 characterized in that each of said conductive means comprises a respective layer of aluminum.

5. The thyristor of any one of the preceding claims characterized in that there are a plurality of gate regions spaced apart from said cathode region on either side thereof.

6. The thyristor of Claim 1 characterized in that the remainder of the outermost surface has a passivation layer.

7. A method of fabricating an asymmetrical field controlled thyristor according to one or more of Claims 1 to 6 characterized by the steps of:

(a) oxidizing a major surface of a semiconductor substrate of said opposite type conductivity having two major surfaces (Fig. 3A);

(b) diffusing dopants into the unoxidized major surface of said substrate to form a more heavily doped layer (31) in said semiconductor substrate than the remaining portion (30) of said substrate, said more heavily doped layer being of the same type conductivity as that of the remaining portion of said substrate (Fig. 3B);

(c) patterning the oxide layer (39) to open a gate diffusion area therein;

(d) diffusing dopants into said substrate through both of said major surfaces so as to produce gate region (33) of said one type conductivity adjoining said remaining portion of said substrate and an anode region (32) of said one type conductivity adjoining said more heavily doped layer in said substrate;

(e) patterning said oxide layer to open only a cathode diffusion area therein;

(f) diffusing dopants into said substrate through said cathode diffusion area opened in said oxide layer so as to provide a cathode region of said opposite type conductivity adjoining said remaining portion of said substrate;

(g) applying a layer of metal onto the outermost surfaces, respectively, of said cathode region and said gate region so as to obtain separate contacts (35, 36) to said cathode region and to said gate region, respectively; and

(h) applying a layer of metal (37) onto the outermost surface of said anode region.

8. The method of Claim 7 characterized in that the patterning step (c) provides a plurality of gate diffusion areas and the diffusion step (d) provides a plurality of gate regions.

**Patentansprüche**

1. Asymmetrischer Feld-gesteuerter Thyristor mit einem Halbleiteranodenbereich (32) eines Leitungstyps,

einem Doppelschicht-Basisbereich (30, 31), benachbart dem Anodenbereich und bestehend aus einem integralen Abschnitt des Halbleitermaterials mit entgegengesetztem Leitungstyp,

einem Kathodenbereich (34), der benachbart der Schicht des Doppelschicht-Basisbereiches liegt, die am weitesten vom Anodenbereich entfernt ist und aus Halbleitermaterial des entgegengesetzten Leitungstyps besteht, wobei der Kathodenbereich mit einer höheren Konzentration des den entgegengesetzten Leitungstyp bestimmenden Dotierungsmittels dotiert ist als beide Schichten des Doppelschicht-Basisbereiches,

einem Halbleiter-Steuerbereich (33), der im Abstand von dem Kathodenbereich liegt, wobei dieser Steuerbereich benachbart dem Doppelschicht-Basisbereich liegt und aus Halbleitermaterial des genannten einen Leitungstyps besteht,

einer ersten leitenden Einrichtung (35), die die äußerste Oberfläche des Kathodenbereiches kontaktiert, einer zweiten leitenden Einrichtung (36), die die äußerste Oberfläche des Steuerbereiches kontaktiert, und

einer dritten leitenden Einrichtung (37), die die äußerste Oberfläche des Anodenbereiches des einen Leitungstyps kontaktiert, dadurch gekennzeichnet, daß

die Schicht (31) des Doppelschicht-Basisbereiches, die dem Anodenbereich am nächsten liegt, mit einer höheren Konzentration des den entgegengesetzten Leitungstyp bestimmenden Dotierungsmittels dotiert ist als die Schicht (30) des Doppelschicht-Basisbereiches, die am weitesten vom Anodenbereich entfernt liegt, und

der Halbleiter-Steuerbereich (33) ein Oberflächen-Steuerbereich ist, der benachbart der Schicht (30) des Doppelschicht-Basisbereiches liegt, die am weitesten von dem Anodenbereich entfernt ist.

2. Thyristor nach Anspruch 1, dadurch gekennzeichnet, daß das Halbleitermaterial des einen Leitungstyps aus einem p-Halbleiter besteht und das Material des entgegengesetzten Leitungstyps aus einem n-Halbleiter besteht.

3. Thyristor nach Anspruch 1 oder 2, dadurch gekennzeichnet, daß das Halbleitermaterial Silizium umfaßt.

4. Thyristor nach Anspruch 1 oder 2 oder 3, dadurch gekennzeichnet, daß jede der leitenden Einrichtungen eine Aluminiumschicht umfaßt.

5. Thyristor nach irgendeinem der vorhergehenden Ansprüche, dadurch gekennzeichnet, daß es mehrere Steuerbereiche gibt, die im Abstand davon auf jeder Seite des Kathodenbereiches angeordnet sind.

6. Thyristor nach Anspruch 1, dadurch gekennzeichnet, daß der Rest der äußersten Oberfläche eine Passivierungsschicht aufweist.

7. Verfahren zum Herstellen eines asymmetrischen Feldgesteuerten Thyristors nach einem oder mehreren der Ansprüche 1 bis 6, gekennzeichnet, durch folgende Stufen:

(a) Oxidieren einer Hauptoberfläche eines Halbleitersubstrates des entgegengesetzten Leitungstyps, das zwei Hauptoberflächen aufweist (Fig. 3A);

(b) Diffundieren von Dotierungsmitteln in die nichtoxidierte Hauptoberfläche des Substrates, um eine stärker dotierte Schicht (31) in dem Halbleitersubstrat zu bilden als es der restliche Teil (30) des Substrates ist, wobei die stärker dotierte Schicht den gleichen Leitungstyp hat wie der restlicht Teil des Substrates (Fig. 3B);

(c) Versehen der Oxidschicht (39) mit einem Muster, um einen Bereich zum Diffundieren eines Steuerbereiches darin zu öffnen,

(d) Diffundieren von Dotierungsmitteln in das Substrat durch beide Hauptoberflächen, um einen Steuerbereich (33) des einen Leitungstyps zu erzeugen, der benachbart dem restlichen Teil des Substrates liegt, und um einen Anodenbereich (32) des einen Leitungstyps zu erzeugen, der benachbart der stärker dotierten Schicht in dem Substrat liegt;

(e) Versehen der Oxidschicht mit einem Muster, um nur einen Bereich zum Diffundieren der Kathode darin zu öffnen;

(f) Diffundieren von Dotierungsmitteln in das Substrat durch den Bereich, der in der Oxidschicht für die Kathode geöffnet worden ist, um so einen Kathodenbereich des entgegengesetzten Leitungstyps zu erzeugen, der benachbart dem restlichen Teil des Substrates liegt;

(g) Aufbringen einer Metalschicht auf die äußersten Oberflächen des Kathodenbereiches und des Steuerbereiches, um separate Kontakte (35, 36) zu den genannten Bereichen zu erhalten; und

(h) Aufbringen einer Metallschicht (37) auf die äußerste Oberfläche des Anodenbereiches.

8. Verfahren nach Anspruch 7, dadurch gekennzeichnet, daß in der Stufe (c) mehrere Bereiche zum Diffundieren von Steuerbereichen und während der Stufe (d) mehrere Steuerbereiche geschaffen werden.

**Revendications**

1. Thyristor asymétrique commandé par champ comprenant:

— une région d'anode (32) semi-conductrice de conductivité d'un premier type;
— une région de base à couche double (30, 31) attenante à la région d'anode et étant constituée par une partie d'un seul tenant d'un matériau semi-conducteur avec une conductivité de type opposé;
— une région de cathode (34) attenante à la couche de la région de base à couche double la plus éloignée de la région d'anode, et étant constituée par le matériau semi-conducteur de conductivité du type opposé, cette région de cathode étant dopée à une concentration plus élevée en dopants du type déterminant la conductivité du type opposé que les deux couches de la région de base à couche double;
— une région de gâchette (33) semi-conductrice espacée de la région de cathode, cette région de gâchette étant attenante à la région de base et étant constituée par le matériau semi-conducteur du premier type de conductivité;
— une premier moyen conducteur (35) en contact avec la surface la plus extérieure de la région de cathode;
— un deuxième moyen conducteur (36) en contact avec la surface la plus extérieure de la région de gâchette; et
— un troisième moyen conducteur (37) en contact avec la surface la plus extérieure de la région d'anode de conductivité du premier type;

thyristor charactérisé en ce que la couche (31) de la région de base à couche double la plus proche de la région d'anode est dopée à une concentration en dopants du type déterminant la conductivité de type opposé plus élevée que la couche (30) de la région de base à couche double la plus éloignée de la région d'anode; et en ce que la région semi-conductrice de gâchette (33) est une gâchette de surface attenante à la couche (30) de la région de base à couche double la plus éloignée de la région d'anode.

2. Thyristor selon la revendication 1, caractérisé en ce que le matériau semi-conducteur du premier type de conductivité consiste en un semi-conducteur de type P et le matériau semi-conducteur de conductivité du type opposé consiste en un semi-conducteur de type N.

3. Thyristor selon l'une quelconque des revendications 1 ou 2, caractérisé en ce que le matériau semi-conducteur est du silicium.

4. Thyristor selon l'une quelconque des revendications 1, 2 ou 3, caractérisé en ce que chacun des moyens conducteurs comporte une couche d'aluminium.

5. Thyristor selon l'une quelconque des revendications précédentes, caractérisé en ce qu'il y a plusieurs régions de gâchette espacées de la région de cathode sur chacun de ses côtés.

6. Thyristor selon la revendication 1, caractérisé en ce que le restant de la surface la plus extérieure a une couche de passivation.

7. Procédé de fabrication d'un thyristor asymètrique commandé par champ selon l'une quelconque des revendications 1 à 6, caractérisé en ce qu'il consiste à:

a) oxyder une surface principale d'un substrat semi-conducteur de conductivité de type opposé comportant deux surface principales (Fig. 3A);
b) diffuser des dopants dans la surface principale non oxydée du substrat pour former une couche plus fortement dopée (31) dans le substrat semi-conducteur que dans la partie restante (30) du substrat, cette couche plus fortement dopée étant du même type de conductivité que la partie restante du substrat (Fig. 3B);
c) graver la couche d'oxyde (39) pour y ouvrir une zone de diffusion de gâchette;
d) diffuser des dopants dans le substrat à travers les deux surfaces principales de manière à réaliser une région de gâchette (33) de conductivité du premier type attenante à la partie restante du substrat et une région d'anode (32) de conductivité du premier type attenante à la couche plus fortement dopée du substrat;
e) graver la couche d'oxyde pour y ouvrir seulement une zone de diffusion de cathode;

f) diffuser des dopants dans le substrat à travers la zone de diffusion de cathode ouverte dans la couche d'oxyde de manière à réaliser une région de cathode de conductivité du type opposé attenante à la partie restante du substrat;

g) appliquer une couche de métal sur les surfaces les plus extérieures, respectivement, de la région de cathode et de la région de gâchette de manière à séparer les contacts (35, 36) de la région de cathode et de la région d'anode, respectivement; et

h) appliquer une couche de métal (37) sur la surface la plus extérieure de la région d'anode.

8. Procédé selon la revendication 7, caractérisé en ce que l'étape de gravure (c) fournit plusieurs zones de diffusion de gâchette et l'étape de diffusion (d) fournit plusieurs régions de gâchette.

FORWARD BLOCKING

REVERSE BLOCKING

ELECTRIC FIELD

$E_P$

*Fig. 1C*

DOPANT CONCENTRATION

$10^{19}$

$P^+$ DIFFUSIONS

N

$\sim 10^{14}$

$10^{19}$

*Fig. 1B*

13

16  15  14  15

19

16

$P^+$

$N^+$

8

9

8

$P^+$

N

$P^+$

13  10  18  12

17

1

*Fig. 1A* PRIOR ART

FORWARD BLOCKING

REVERSE BLOCKING

ELECTRIC FIELD

$E_P$

*Fig. 2C*

DOPANT CONCENTRATION

$10^{19}$

$P^+$ DIFFUSIONS

N DIFFUSION

$10^{17}$

$10^{19}$

$\sim 10^{12}$

*Fig. 2B*

33

36  39  35  39  36

34

$P^+$

$N^+$

42

41

$P^+$

41

$N^-$

N

$P^+$

33  30  31  43  32

37

2

*Fig. 2A*

*Fig. 1D*

*Fig. 2D*

Fig.3A

Fig.3B

Fig.3C

Fig.3D

Fig.3E

Fig.3F